# EUROPEAN PATENT APPLICATION

(11) **EP 2 348 002 A1**
(43) Date of publication of application: **27.07.2011**
(21) Application number: 09826135.7
(22) Date of filing: 12.11.2009
(51) Int. Cl.: C03C 27/06, C03C 17/34, H01L 31/02, H01L 51/50, H05B 33/04

(54) **METHOD FOR PRODUCING GLASS MEMBER PROVIDED WITH SEALING MATERIAL LAYER, AND METHOD FOR MANUFACTURING ELECTRONIC DEVICE**

(30) Priority: 14.11.2008 JP 2008291967
(71) Applicant: Asahi Glass Company Limited, Chiyoda-ku Tokyo 100-8405 (JP)
(72) Inventor: SHIBUYA, Koichi, Tokyo 100-8405 (JP); IDE, Asahi, Tokyo 100-8405 (JP); KAWANAMI, Sohei, Koriyama-shi Fukushima 963-0215 (JP)
(74) Representative: Müller-Boré & Partner Patentanwälte
(86) International application number: PCT/JP2009/069289
(87) International publication number: WO 2010/055888

(57) **Abstract**

Laser sealing property and reliability of a glass panel are increased by suppressing cracks, fractures, separation and the like of glass substrates and a sealing material layer at the time of laser sealing.

A first paste for a sealing material containing no laser absorbent and a second paste for a sealing material containing a laser absorbent are applied in this order on a sealing region 2a of a glass substrate 2. A laminate film of a coating layer 11 of the first paste for a sealing material and a coating layer 12 of the second paste for a sealing material is fired, to form a sealing material layer 3 having a laminated structure of a layer 4 of the first glass material for sealing and a layer 5 of the second glass material for sealing. The second glass substrate 2 having such a sealing material layer 3 is laminated with a glass substrate having an element-formed region, and the sealing material layer 3 is irradiated with a laser light from the side of the layer 4 of the first glass material for sealing through the second glass substrate 2 for bonding.

## Description

### TECHNICAL FIELD

The present invention relates to a process for producing a glass member provided with a sealing material layer and a process for producing an electronic device.

### BACKGROUND ART

A flat panel display device (FPD) such as an organic EL (electro-luminescence) display (OELD), a plasma display panel (PDP) or a liquid crystal display device (LCD) has such a structure that a glass substrate for an element having a light-emitting element formed and a glass substrate for sealing are disposed to face each other and the light-emitting element is sealed in a glass package comprising two such glass substrates bonded (Patent Document 1). Further, for a solar cell such as a dye-sensitized solar cell, application of a glass package having a solar cell element (photoelectric conversion element) sealed with two glass substrates has been studied (Patent Document 2).

As a sealing material to seal a space between two glass substrates, a sealing resin or a sealing glass has been used. Since an organic EL (OEL) element or the like is likely to undergo deterioration by water, application of sealing glass excellent in the moisture resistance, etc. is in progress. Since the sealing temperature of the sealing glass is at a level of from 400 to 600°C, properties of an electronic element portion of the OEL element or the like will be deteriorated when firing is conducted by using a conventional heating furnace. Accordingly, it has been attempted that a layer of a glass material for sealing containing a laser absorbent is disposed between sealing regions provided on the peripheral portions of two glass substrates, and the layer of the glass material for sealing is irradiated with a laser light to heat and melt the layer thereby to conduct sealing (Patent Documents 1 and 2).

Sealing by irradiation with laser (laser sealing) can suppress thermal influences over the electronic element portion, and on the contrary, it has a disadvantage that cracks, fractures and the like are likely to form on the glass substrate at the time of sealing. In a case where the laser sealing is applied, first, a glass material for sealing containing a laser absorbent is burnt on a sealing region of a glass substrate for sealing to form a layer of the glass material for sealing. Then, the glass substrate for sealing and a glass substrate for an element are laminated via the layer of the glass material for sealing, and the laminate is irradiated with a laser light from the side of the glass substrate for sealing to heat and melt the entire layer of the glass material for sealing thereby to seal a space between the glass substrates.

Since the laser absorbent is uniformly dispersed in the layer of the glass material for sealing, the laser absorbent present in the vicinity of the interface between the glass substrate for sealing and the layer of the glass material for sealing intensely absorbs a laser light when irradiated with a laser light, whereby the portion in the vicinity of the interface locally generates heat. Cracks, fractures and the like form on the glass substrate due to such local heat generation. Alkali-free glass or soda lime glass is used for a glass substrate constituting the glass panel, and particularly soda lime glass has a high thermal expansion coefficient, and accordingly cracks, fractures and the like are likely to form at the time of laser sealing.

Patent Document 3 discloses, to increase the thickness of the sealing layer, formation of a transparent layer of a first glass material for sealing containing no laser absorbent and an opaque layer of a second glass material for sealing containing a laser absorbent in this order on the glass substrate for sealing. In this case, after a layer of the first glass material for sealing is formed by means of a firing step, a layer of the second glass material for sealing is formed on the above layer by means of another firing step. In such a case, at the time of the laser irradiation, a portion in the vicinity of the interface between the layer of the first glass material for sealing containing no laser absorbent and the layer of the second glass material for sealing containing a laser absorbent is likely to locally generate heat. Accordingly, the two layers of a glass material for sealing may be separated at their interface, or cracks, fractures and the like may form on the portion in the vicinity of the interface, thus leading to a decrease in the sealing reliability.

### PRIOR ART DOCUMENTS

### PATENT DOCUMENTS

Patent Document 1: JP-A-2006-524419
Patent Document 2: JP-A-2008-115057
Patent Document 3: JP-A-2007-200836

### DISCLOSURE OF INVENTION

### TECHNICAL PROBLEM

It is an object of the present invention to provide a process for producing a glass member provided with a sealing material layer and a process for producing an electronic device, with which the sealing property and the reliability can be increased by suppressing cracks, fractures, separation and the like of a glass substrate and a layer of a glass material for sealing at the time of the laser sealing.

### SOLUTION TO PROBLEM

The process for producing a glass member provided with a sealing material layer according to one embodiment of the present invention comprises a step of preparing a glass substrate having a sealing region; a step of applying a first paste for a sealing material which contains a first glass material for sealing containing no laser absorbent and a second paste for a sealing material which contains a second glass material for sealing containing a laser absorbent, in this order on the sealing region of the glass substrate; and a step of firing a laminate film of a coating layer of the first paste for a sealing material and a coating layer of the second paste for a sealing material, to form a sealing material layer having a laminated structure of a layer of the first glass material for sealing and a layer of the second glass material for sealing on the sealing region.

The process for producing an electronic device according to another embodiment of the present invention comprises a step of preparing a first glass substrate having an element-formed region provided with an electronic element and a first sealing region provided on the outer peripheral side of the element-formed region; a step of preparing a second glass substrate having a second sealing region corresponding to the first sealing region of the first glass substrate; a step of applying a first paste for a sealing material which contains a first glass material for sealing containing no laser absorbent and a second paste for a sealing material which contains a second glass material for sealing containing a laser absorbent, in this order on the second sealing region of the second glass substrate; a step of firing a laminate film of a coating layer of the first paste for a sealing material and a coating layer of the second paste for a sealing material, to form a sealing material layer having a laminated structure of a layer of the first glass material for sealing and a layer of the second glass material for sealing, on the second sealing region; a step of laminating the first glass substrate and the second glass substrate via the sealing material layer while a space is formed on the element-formed region; and a step of irradiating the sealing material layer with a laser light from the side of the layer of the first glass material for sealing through the second glass substrate to melt at least the layer of the second glass material for sealing thereby to seal the space between the first glass substrate and the second glass substrate.

### ADVANTAGEOUS EFFECT OF INVENTION

According to the process for producing a glass member provided with a sealing material layer and the process for producing an electronic device according to the embodiments of the present invention, local heat generation in the vicinity of an interface at the time of the laser irradiation will be suppressed since the structure of the interface between the layer of the first glass material for sealing and the layer of the second glass material for sealing is improved. Thus, it is possible to suppress cracks, fractures, separation and the like of the glass substrate or the layer of the glass material for sealing when the space between the two glass substrates is sealed by laser.

### BRIEF DESCRIPTION OF DRAWINGS

Fig. 1 is cross-sectional views illustrating the process for production of an electronic device according to the embodiment of the present invention.
Fig. 2 is a plan view illustrating a first glass substrate used in the process for production of an electronic device shown in Fig. 1.
Fig. 3 is a cross-sectional view along the line A-A in Fig. 2.
Fig. 4 is a plan view illustrating a second glass substrate used in the process for production of an electronic device shown in Fig. 1.
Fig. 5 is a cross-sectional view along the line A-A in Fig. 4.
Fig. 6 is cross-sectional views illustrating the procedure for formation of a sealing material layer on a second glass substrate in the process for production of an electronic device shown in Fig. 1.

### DESCRIPTION OF EMBODIMENTS

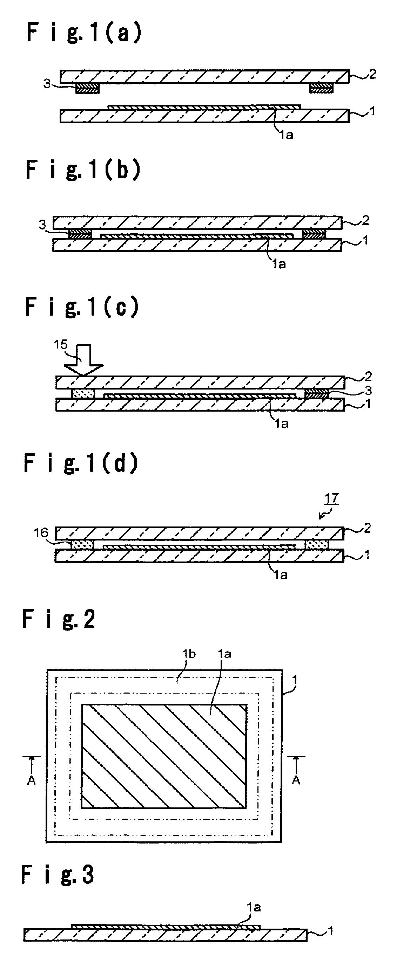

Now, the embodiments of the present invention will be described with reference to drawings. Figs 1 to 6 are views illustrating the process for production of an electronic device according to the embodiment of the present invention. As an electronic device to which the production process according to the embodiment of the present invention is applied, a FPD such as an OELD, a PDP or a LCD, an illumination apparatus employing a light emitting element such as an OEL element, or a sealed type solar cell such as a dye-sensitized solar cell may be mentioned.

As shown in Fig. 1(a), a first glass substrate 1 and a second glass substrate 2 are prepared. The first glass substrate 1 has an element-formed region 1 a having an electronic element as shown in Figs. 2 and 3. On the element-formed region 1 a, an electronic element depending on an electronic device, for example, an OEL element for an OELD or OEL illumination, a plasma light-emitting element for a PDP, a liquid crystal display element for a LCD, or a dye-sensitized photoelectric conversion part for a solar cell, is formed. Each of a light emitting element such as an OEL element and a solar cell element such as a dye-sensitized photoelectric conversion part has known structures.

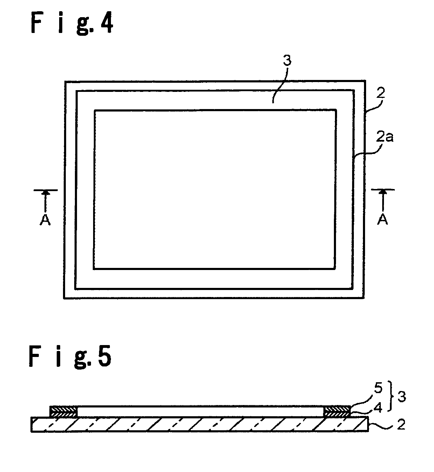

The first glass substrate 1 has a first sealing region 1 b provided on the outer peripheral side of the element-formed region 1a. The first sealing region 1 b is provided so as to surround the element-formed region 1 a. On the other hand, the second glass substrate 2 has a second sealing region 2a shown in Figs. 4 and 5. The second sealing region 2a is to correspond to the first sealing region 1 b. That is, the first sealing region 1 b and the second sealing region 2a are provided so as to face each other when the first glass substrate 1 and the second glass substrate 2 are disposed to face each other, to be a sealing layer-formed region (a sealing material layer-formed region with respect to the second glass substrate 2) as described hereinafter.

Each of the first and second glass substrates 1 and 2 comprises alkali-free glass, soda lime glass or the like. Alkali-free glass has a thermal expansion coefficient at a level of from 35 to 40×10⁻⁷/°C. Soda lime glass has a thermal expansion coefficient at a level of from 85 to 90×10⁻⁷/°C.

In the sealing region 2a of the second glass substrate 2, a sealing material layer 3 in a double-layer structure is formed as shown in Figs. 4 and 5. The sealing material layer 3 has a laminated structure of a layer 4 of a first glass material for sealing containing no laser absorbent and a layer 5 of a second glass material for sealing containing a laser absorbent. On the second sealing region 2a, the layer 4 of a first glass material for sealing containing no laser absorbent is formed, and the layer 5 of a second glass material for sealing containing a laser absorbent is formed thereon.

Irradiation of the sealing material layer 3 with a laser light is carried out via the second glass substrate 2 as described in detail hereinafter. When the sealing material layer 3 is irradiated with a laser light via the second glass substrate 2, the laser light passes through the layer 4 of a first glass material for sealing and reaches the layer 5 of a second glass material for sealing disposed on the first glass substrate 1 side since the layer 4 which forms an interface with the second glass substrate 2 contains no laser absorbent. Since the layer 5 of a second glass material for sealing contains a laser absorbent, the laser light is absorbed in the layer 5 of a second glass material for sealing, which generates heat.

Since the laser light is selectively absorbed in the layer 5 of a second glass material for sealing, the layer 5 of a second glass material for sealing disposed on the first glass substrate 1 side can be selectively heated and melted. Accordingly, the portion in the vicinity of the interface between the first glass substrate 1 and the sealing material layer 3 will not locally be heated and generate heat, and accordingly cracks, fractures and the like of the glass substrate 2 can be suppressed. Since the layer 4 of a first glass material for sealing is fixed on the second glass substrate 2, it is possible to favorably seal the space between the first glass substrate 1 and the second glass substrate 2 by melting at least the layer 5 of a second glass material for sealing.

The thickness of the sealing material layer 3 is properly selected depending on the required space between the first glass substrate 1 and the second glass substrate 2. The process for production according to this embodiment is particularly effective in a case where the thickness of the sealing material layer should be at least 10 µm. Even in a case where the sealing material layer 3 having such a thickness is irradiated with a laser light for bonding, by applying a sealing material layer 3 having a laminated structure of the layer 4 of a first glass material for sealing containing no laser absorbent and the layer 5 of a second glass material for sealing containing a laser absorbent, favorable hermetic sealing property can be obtained and in addition, failures by cracks or fractures of the glass substrate 1 or 2, separation or fractures of the sealing layer, or the like can be suppressed.

The first glass material for sealing comprises sealing glass as the main component and a low-expansion filler or the like incorporated. The second glass material for sealing comprises sealing glass as the main component, and a low-expansion filler or the like and in addition, a laser absorbent incorporated. For the sealing glass (glass frit) as the main component of each of the first and second glass materials for sealing, for example, low melting glass such as tin-phosphate glass, bismuth glass, vanadium glass or lead glass may be used. Among them, considering the sealing property (adhesion property) to the glass substrates 1 and 2 and the reliability (bonding reliability and hermetically sealing property) and in addition, the influences over the environment and the human body, it is preferred to use sealing glass comprising tin-phosphate glass or bismuth glass.

The tin-phosphate glass (glass frit) preferably has a composition comprising from 20 to 68 mass% of SnO, from 0.5 to 5 mass% of SnO₂ and from 20 to 40 mass% of P₂O₅ (the total amount will be 100 mass%). SnO is a component to make the glass have a low melting point. If the content of SnO is less than 20 mass%, the viscosity of glass will be high and the sealing temperature will be too high, and if the content exceeds 68 mass%, the glass will not be vitrified.

SnO₂ is a component to stabilize glass. If the content of SnO₂ is less than 0.5 mass%, SnO₂ will be separated and precipitate in the glass softened and melted at the time of the sealing operation, and the fluidity will be impaired and the sealing operation property will be decreased. If the content of SnO₂ exceeds 5 mass%, SnO₂ is likely to precipitate in the melt of the low melting glass. P₂O₅ is a component to form a glass skeleton. If the content of P₂O₅ is less than 20 mass%, the glass will not be vitrified, and if the content exceeds 40 mass%, deterioration of the weather resistance which is a drawback specific to phosphate glass may occur.

The glass formed by the above three components has a low glass transition point and is suitable as a sealing material at low temperature, and it may contain e.g. a component to form a glass skeleton such as SiO₂, a component to stabilize the glass such as ZnO, B₂O₃, Al₂O₃, WO₃, MoO₃, Nb₂O₅, TiO₂, ZrO₂, Li₂O, Na₂O, K₂O, Cs₂O, MgO, CaO, SrO or BaO as an optional component. However, if the content of the optional component is too high, the glass will be unstable, whereby devitrification may occur, or the glass transition point or the softening point may be increased. Thus, the total content of the optional components is preferably at most 30 mass%.

The bismuth glass (glass frit) preferably has a composition comprising from 70 to 90 mass% of Bi₂O₃, from 1 to 20 mass% of ZnO and from 2 to 12 mass% of B₂O₃ (the total content will be 100 mass%). Bi₂O₃ is a component to form a glass network. If the content of Bi₂O₃ is less than 70 mass%, the softening point of the low melting glass will be high, whereby sealing at low temperature will be difficult. If the content of Bi₂O₃ exceeds 90 mass%, the glass will hardly be vitrified and in addition, the thermal expansion coefficient tends to be too high.

ZnO is a component to lower the thermal expansion coefficient or the like. If the content of ZnO is less than 1 mass%, the glass will hardly be vitrified. If the content of ZnO exceeds 20 mass%, the stability at the time of formation of the low melting glass will be decreased, and devitrification is likely to occur. B₂O₃ is a component to form a glass skeleton and to broaden a range within which the glass can be vitrified. If the content of B₂O₃ is less than 2 mass%, the glass will hardly be vitrified, and if it exceeds 12 mass%, the softening point will be too high, whereby sealing at low temperature will be difficult even if a load is applied at the time of the sealing.

The glass formed by the above three components has a low glass transition point and is suitable as a sealing material at low temperature, and it may contain an optional component such as Al₂O, CeO₂, SiO₂, Ag₂O, MoO₃, Nb₂O₃, Ta₂O₅, Ga₂O₃, Sb₂O₃, Li₂O, Na₂O, K₂O, Cs₂O, CaO, SrO, BaO, WO₃, P₂O₅ or SnOₓ (wherein x is 1 or 2). However, if the content of the optional components is too high, the glass will be unstable, whereby devitrification may occur, or the glass transition point or the softening point may be increased. Thus, the total content of the optional components is preferably at most 30 mass%.

Each of the first and second glass materials for sealing preferably contains a low-expansion filler. As the low-expansion filler, it is preferred to use at least one member selected from silica, alumina, zirconia, zirconium silicate, cordierite, a zirconium phosphate compound, soda lime glass and borosilicate glass. The zirconium phosphate compound may be (ZrO)₂P₂O₇, AZr₂(PO₄)₃ (wherein A is at least one member selected from Na, K and Ca), NbZr₂(PO₄)₃, Zr₂(WO₃)(PO₄)₂ or a composite compound thereof. Further, the low-expansion filler is one having a lower thermal expansion coefficient than the sealing glass as the main component of the glass material for sealing, and is to decrease the thermal expansion coefficient of the glass material for sealing.

The content of the low-expansion filler is properly set so that the thermal expansion coefficient of the sealing glass is close to the thermal expansion coefficients of the glass substrates 1 and 2. The low-expansion filler is contained in an amount of from 3 to 50 mass% to the glass material for sealing, although it depends on the thermal expansion coefficients of the sealing glass and the glass substrates 1 and 2. In a case where each of the glass substrates 1 and 2 is formed by alkali-free glass (thermal expansion coefficient: 35 to 40×10⁻⁷/°C), it is preferred to add a relatively large amount (for example from 30 to 50 mass%) of the low-expansion filler. In a case where each of the glass substrates 1 and 2 is formed by soda lime glass (thermal expansion coefficient: 85 to 90×10⁻⁷/°C), it is preferred to add a relatively small amount (for example from 3 to 40 mass%) of the low-expansion filler.

The second glass material for sealing contains a laser absorbent. As the laser absorbent, at least one metal selected from Fe, Cr, Mn, Co, Ni and Cu, or a compound such as an oxide containing the metal may be used. The content of the laser absorbent is preferably within a range of from 0.1 to 10 mass%, more preferably from 2 to 6 mass% to the glass material for sealing. If the content of the laser absorbent is less than 0.1 mass%, the layer 5 of the second glass material for sealing may not sufficiently be melted. If the content of the laser absorbent exceeds 10 mass%, a portion in the vicinity of an interface with the laser 4 of the first glass material for sealing may locally generate heat, and the fluidity of the second glass material for sealing at the time of melting may be deteriorated, whereby the adhesion to the first glass substrate 1 may be decreased.

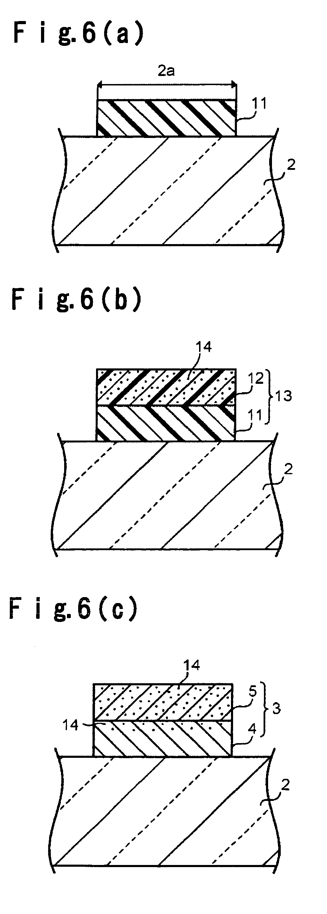

The sealing material layer 3 in a double-layer structure is formed as follows. The process for formation of the sealing material layer 3 will be described with reference to Fig. 6. Fig. 6 is to illustrate the embodiment of the glass member provided with a sealing material layer of the present invention. First, first and second glass materials for sealing are respectively mixed with a vehicle to prepare first and second pastes for a sealing material.

The vehicle may, for example, be one having methyl cellulose, ethyl cellulose, carboxymethyl cellulose, oxyethyl cellulose, benzyl cellulose, propyl cellulose, nitrocellulose or the like dissolved in a solvent such as terpineol, butyl carbitol acetate or ethyl carbitol acetate, or one having an acrylic resin of e.g. methyl (meth)acrylate, ethyl (meth)acrylate, butyl (meth)acrylate or 2-hydroxyethyl methacrylate dissolved in a solvent such as methyl ethyl ketone, terpineol, butyl carbitol acetate or ethyl carbitol acetate.

The viscosity of the paste for a sealing material is fitted to the viscosity in accordance with an apparatus which applies the paste on the glass substrate 2, and may be adjusted by the ratio of the resin (binder component) to the solvent or the ratio of the glass material for sealing to the vehicle. To the paste for a sealing material, known additives for a glass paste, such as an antifoaming agent or a dispersing agent may be added. For preparation of the paste for a sealing material, a known method employing a rotary mixer equipped with a stirring blade, a roll mill, a ball mill or the like may be applied.

First, as shown in Fig. 6(a), on a sealing region 2a of a second glass substrate 2, a first paste for a sealing material which contains a first glass material for sealing containing no laser absorbent is applied and dried to form a first coating layer 11. Then, as shown in Fig. 6(b) on the first coating layer 11 before firing, a second paste for a sealing material which contains a second glass material for sealing containing a laser absorbent is applied and dried to form a second coating layer 12. In such a manner, a laminate film 13 of the first coating layer 11 and the second coating layer 12 is formed. In the second coating layer 12, a laser absorbent 14 is dispersed based on the second glass material for sealing containing a laser absorbent.

Each of the first and second pastes for a sealing material is applied on the second sealing region 2a employing, for example, a printing method such as screen printing or gravure printing, or applied along the second sealing region 2a using a dispenser or the like. Each of the first and second coating layers 11 and 12 is dried, for example, at a temperature of at least 120°C for at least 5 minutes. The drying step is carried out to remove the solvent in the coating layers 11 and 12. If the solvent remains in the coating layer 11 or 12, the binder component may not sufficiently be removed in the following firing step.

The thicknesses of the first and second coating layers 11 and 12 can be properly set depending on the thickness of the sealing material layer 3. However, if the second coating layer 12 and a layer 5 of the second glass material for sealing based on the second coating layer 12 are too thin, adhesion to a first glass substrate 1 may be decreased, and accordingly the thickness of the second coating layer 12 is preferably at least 5 µm. The thicknesses of the first coating layer 11 and a layer 4 of the first glass material for sealing based on the first coating layer 11 are properly set depending on the thickness of the sealing material layer 3 and the thickness of the second coating layer 12. Each of the thicknesses of the first and second coating layers 11 and 12 is preferably from 10 to 200 µm, more preferably from 20 to 80 µm.

Then, as shown in Fig. 6(c), a laminate film 13 of the first coating layer 11 and the second coating layer 12 is fired to form a sealing material layer 3 having a laminated structure of the layer 4 of the first glass material for sealing and the layer 5 of the second glass material for sealing. In the step of firing the laminate film 13, first, the laminate film 13 is heated to a temperature of at most the glass transition point of the sealing glass (glass frit) as the main component in the glass material for sealing, to remove binder components in the coating layers 11 and 12, and then heated to a temperature of at least the softening point of the sealing glass (glass frit) to melt the glass material for sealing and burn it on the glass substrate 2. The burning conditions depend on the sealing material to be used, and in the case of bismuth glass, the temperature for firing the laminate film 13 is preferably from 420 to 520°C, more preferably from 450 to 470°C. In the case of tin-phosphate glass, the temperature for firing the laminate film 13 is preferably from 400 to 500°C, more preferably from 420 to 440°C. Further, the time for firing the laminate film 13 is preferably from 5 to 60 minutes, more preferably from 8 to 15 minutes either in the cases of bismuth glass and tin-phosphate glass.

In the above-described step of forming the coating layers 11 and 12 (the step of applying the paste) and the step of forming the sealing material layer 3 (the step of firing the laminate film 13), at the stage of the laminate film 13, part of the laser absorber 14 in the second coating layer 12 sinks to the first coating layer 11 side. Also at the stage of firing the laminate film 13 of the first coating layer 11 and the second coating layer 12, the laser absorbent 14 present in the second coating layer 12 is diffused to the first coating layer 11. Accordingly, in the sealing material layer 3 formed by firing the laminate film 13 of the first coating layer 11 and the second coating layer 12, the laser absorbent 14 is present not only in the layer 5 of the second glass material for sealing but also in the layer 4 of the first glass material for sealing.

The laser absorbent 14 in the layer 4 of the first glass material for sealing is based on diffusion from the layer 5 of the second glass material for sealing, and accordingly it is present in the vicinity of an interface between the layer 4 of the first glass material for sealing and the layer 5 of the second glass material for sealing. On the other hand, since part of the laser absorbent 14 in the layer 5 of the second glass material for sealing is diffused to the side of the layer 4 of the first glass material for sealing via the interface, the concentration of the laser absorbent 14 in the vicinity of the interface is decreased. Accordingly, a sealing material layer 3 having a laminated structure (double-layer structure) with a concentration gradient of the laser absorbent 14 can be obtained. The thickness of the sealing material layer 3 is preferably from 6 to 120 µm, more preferably from 15 to 65 µm.

Here, if a coating layer of the paste for a sealing material containing no laser absorbent is fired and then the paste for a sealing material containing a laser absorbent is applied and fired, the laser absorbent cannot be diffused via the laminate interface, and a layer (4) of a glass material for sealing containing no laser material and a laser (5) of the glass material for sealing containing a laser absorbent are in a separated state. In such a case, the portion in the vicinity of the laminate interface locally generates heat at the time of irradiation with a laser light, whereby the interface separation may occur, or separation or cracks are likely to form based on the residual stress caused between the two layers.

According the step of forming the sealing material layer 3 according to this embodiment, there is a concentration gradient of the laser absorbent 14 via the interface between the layer 4 of the first glass material for sealing and the layer 5 of the second glass material for sealing, and accordingly local heat generation in the vicinity of the interface at the time of the irradiation of the sealing material layer 3 with a laser light can be prevented. Accordingly, the thermal stress between the two layers is relaxed, whereby it is possible to suppress e.g. separation from the interface or cracks in the vicinity of the interface. That is, the sealing material layer 3 is favorably melted at the time of irradiation with a laser light and a good sealing layer (a layer having the sealing material layer 3 melted and solidified) can be obtained without the interface separation, cracks and the like in a quenching procedure after the melting.

In order to accelerate diffusion of the laser absorbent 14 via the interface between the layer 4 of the first glass material for sealing and the layer 5 of the second glass material for sealing, the second coating layer 12 is preferably formed on the first coating layer 11 having its surface roughened. By applying the second paste for a sealing material containing the laser absorbent 14 on the first coating layer 11 having its surface roughened, distribution of the laser absorbent 14 in the vicinity of the interface between the layer 4 of the first glass material for sealing and the layer 5 of the second glass material for sealing after firing can be broadened, whereby the concentration of the laser absorbent 14 in the layer 4 of the first glass material for sealing and thus the concentration gradient of the laser absorbent 14 in the sealing material layer 3 can be increased.

The surface of the first coating layer 11 can be roughened by employing a means of e.g. using a low boiling point solvent for the first paste for a sealing material, reducing the amount of the solvent in the first paste for a sealing material, making the mesh coarse when the first paste for a sealing material is applied, shortening the time for leveling treatment (treatment to make the surface smooth after application of the paste) after the first paste for a sealing material is applied, or increasing the rate of drying the first paste for a sealing material (for example, increasing the drying temperature or increasing the drying efficiency). The surface roughness of the second coating layer 12 is, as represented by Ra (measured by a surface roughness measuring apparatus (SURFCOM) manufactured by TOKYO SEIMITSU CO., LTD.), preferably at least 0.2 µm, more preferably from 0.24 to 0.60 µm.

Further, in the above description, a double-layer laminate film of coating layers of the paste for a sealing material is employed, however, for example, a laminate film having at least three coating layers differing in the concentration of the laser absorbent 14 may be employed. In such a case, a plurality of pastes for a sealing material having their laser absorbent contents adjusted so that the concentration of the laser absorbent decreases toward the first coating layer 11 containing no laser absorbent, to form a plurality of coating layers (12) containing a laser absorbent. By employing such a coating structure, the concentration gradient of the laser absorbent 14 can be more increased.

By using a second glass substrate 2 having the above-described sealing material layer 3, and a separately prepared first glass substrate 1 having an element-formed region provided with an electronic element, an electronic device such as an FPD such as an OELD, a PDP or a LCD, an illumination apparatus using an OEL element, or a solar cell such as a dye-sensitized solar cell, is prepared. That is, as shown in Fig. 1(b), the first glass substrate 1 and the second glass substrate 2 are laminated so that a face having an element-formed region 1 a and a face having the sealing material layer 3 face each other. On the element-formed region 1 a of the first glass substrate 1, a space is formed based on the thickness of the sealing material layer 3.

Then, as shown in Fig. 1(c), the sealing material layer 3 is irradiated with a laser light 15 through the second glass substrate 2. The laser light 15 is applied with scanning along the sealing material layer 3 in the form of a frame. The laser light 15 is not limited, and a laser light from e.g. a semiconductor laser, a carbon dioxide laser, an excimer laser, a YAG laser or a HeNe laser may be employed. The output of the laser light 15 is properly set depending on e.g. the thickness of the sealing material layer 3, and is preferably within a range of from 2 to 150 W for example. If the laser output is less than 2 W, the sealing material layer 3 may not sometimes be melted, and if it exceeds 150 W, the glass substrates 1 and 2 are likely to have cracks, fractures and the like. The laser output is more preferably within a range of from 5 to 100 W.

Since the layer 4 of the first glass material for sealing forming the interface with the second glass substrate 2 contains no laser absorbent, the laser light 15 is selectively absorbed in the layer 5 of the second glass material for sealing containing a laser absorbent. Thus, the layer 5 of the second glass material for sealing is selectively heated and melted, which is quenched and bonded to the first glass substrate 1. The layer 4 of the first glass material for sealing is heated by e.g. the radiant heat or the heat transfer from the layer 5 of the second glass material for sealing. Part of or all the layer 4 of the first glass material for sealing may be melted by such heating, or only the layer 5 of the second glass material for sealing may be melted.

And, by irradiating the perimeter of the sealing material layer 3 with the laser light 15, a sealing layer 16 to seal the space between the first glass substrate 1 and the second glass substrate 2 is formed as shown in Fig. 1 (d). In such a manner, an electronic device 17 having an electronic element formed in the element-formed region 1a hermetically sealed by a glass panel comprising the first glass substrate 1, the second glass substrate 2 and the sealing layer 16, is prepared. The glass panel the interior of which is hermetically sealed is not limited to the electronic device 17, and can be applied to a sealed product (package) of an electronic component, or a glass member (e.g. a building material) such as vacuum double glazing.

In the process for production of the electronic device 17 according to this embodiment, the sealing material layer 3 is formed by the layer 4 of the first glass material for sealing containing no laser absorbent and the layer 5 of the second glass material for sealing containing a laser absorbent, and accordingly the portion in the vicinity of the interface between the first glass substrate 1 and the sealing material layer 3 will not locally be heated to generate heat at the time of irradiation with the laser light 15. Further, there is a concentration gradient of the laser absorbent 14 via the interface between the layer 4 of the first glass material for sealing and the layer 5 of the second glass material for sealing by firing the laminate film 13 of the first coating layer 11 and the second coating layer 12, and accordingly local heat generation in the sealing material layer 3 at the time of irradiation with the laser light 15 can be prevented.

Accordingly, it is possible to suppress not only cracks and fractures of the glass substrate 2 due to local heat generation at the portion in the vicinity of the interface between the first glass substrate 1 and the sealing material layer 3, but also separation from the interface between the layer 4 of the first glass material for sealing and the layer 5 of the second glass material for sealing due to local heat generation in the sealing material layer 3, and further, separation, cracks and the like by the residual stress between the layers 4 and 5 of the glass material for sealing. Accordingly, the sealing material layer 3 can be favorably melted at the time of irradiation with a laser light, and a good sealing layer 16 can be obtained without cracks, the interface separation and the like in the quenching procedure after the melting. That is, it is possible to prepare an electronic device 17 of which the space between the first and second glass substrates 1 and 2 is hermetically sealed, with a high yield.

### EXAMPLES

Now, the present invention will be described in detail with reference to specific Examples and the evaluation results. However, it should be understood that the present invention is by no means restricted to the following specific Examples, and modification within the scope of the present invention is possible.

### EXAMPLE 1

First, tin-phosphate glass frit (softening point: 401°C) having a composition comprising, by mass ratio, 63.0% of SnO, 2.0% of SnO₂, 29.5% of P₂O₅, 5.0% of ZnO and 0.5% of SiO₂, and having an average particle size of 3 µm, a zirconium phosphate ((ZrO)₂P₂O₇) powder having an average particle size of 3 µm as a low-expansion filler, and a laser absorbent having a composition comprising, by mass ratio, 35% of Fe₂O₃, 35% of Cr₂O₃, 20% of Co₂O₃ and 10% of MnO, and having an average particle size of 2 µm, were prepared. Further, 4 mass% of nitrocellulose as a binder component was dissolved in 96 mass% of a solvent comprising butyl carbitol acetate to prepare a vehicle.

53 Mass% of the tin-phosphate glass frit and 47 mass% of the zirconium phosphate powder were mixed. The thermal expansion coefficient of the mixture is 45×10⁻⁷/°C. 80 Mass% of the mixture (first glass material for sealing) of the glass frit with the low-expansion filler was mixed with 20 mass% of the vehicle to prepare a first paste for a sealing material. Then, 100 parts by mass of the mixture of the glass frit with the low-expansion filler was mixed with 4 parts by mass (3.8 mass% to the glass material for sealing) of the laser absorbent, and 80 mass% of this mixture (second glass material for sealing) was mixed with 20 mass% of the vehicle to prepare a second paste for a sealing material.

Then, on the outer peripheral region of a second glass substrate (dimensions: 90x90x0.7 mmt) comprising alkali-free glass (thermal expansion coefficient: 38x 10⁻⁷/°C), the first paste for a sealing material containing no laser absorbent was applied (line width: 1 mm) by a screen printing method. The resulting first coating layer was left at rest for one minute for leveling treatment and then dried at 130°C for 5 minutes. A standard time for leveling treatment (time until the print trace disappeares) is about 5 minutes.

On the first coating layer after dried, the second paste for a sealing material containing a laser absorbent was applied by a screen printing method. The resulting second coating layer was dried at 130°C for 5 minutes. The thickness of the first coating layer after dried was 17 µm, and the thickness (total thickness) of the coating layers after dried, after the second paste for a sealing material was applied, was 35 µm. The laminate film of such coating layers was fired at 430°C for 10 minutes to form a sealing material layer having a thickness of 31 µm.

The second glass substrate having the above-described sealing material layer and a first glass substrate comprising alkali-free glass (thermal expansion coefficient: 38×10⁻⁷/°C) having an element-formed region (a region on which an OEL element was formed) were laminated. Then, the sealing material layer was irradiated with a laser light (semiconductor laser) having a wavelength of 940 nm at an output of 30 W at a scanning rate of 10 mm/s through the second glass substrate to melt and quench to solidify at least the layer of the second glass material for sealing thereby to bond the first glass substrate and the second glass substrate. In such a manner, an electronic device having the element-formed region sealed in a glass panel was prepared and subjected to the after-mentioned evaluation of properties.

### EXAMPLE 2

First and second pastes for a sealing material were prepared in the same manner as in Example 1 except that a zirconium phosphate powder having an average particle size of 7 µm was used as a low-expansion filler and that 100 parts by mass of the mixture of the glass frit with the low-expansion filler was mixed with 2 parts by mass (1.96 mass% to the glass material for sealing) of the laser absorbent for the second glass material for sealing.

Then, on the outer peripheral region of the same second glass substrate as in Example 1, the first paste for a sealing material was applied by a screen printing method. The first coating layer was subjected to leveling treatment for 5 minutes (standard time) and dried at 150°C for 5 minutes. Then, in the same manner as in Example 1, the second paste for a sealing material was applied and dried and then fired at 430°C for 10 minutes to form a sealing material layer. The thickness (after dried) of the first coating layer was 34 µm, and the total thickness (after dried) after application of the second paste for a sealing material was 70 µm. The thickness of a sealing material layer formed by firing the laminate film of such coating layers is 63 µm.

The second glass substrate having the sealing material layer and a first glass substrate comprising alkali-free glass (thermal expansion coefficient: 38×10⁻⁷/°C) having an element-formed region (a region on which an OEL element was formed) were laminated. Then, the sealing material layer was irradiated with a laser light (semiconductor laser) having a wavelength of 940 nm at an output of 25 W at a scanning rate of 10 mm/s through the second glass substrate to melt and quench to solidify at least the layer of the second glass material for sealing thereby to bond the first glass substrate and the second glass substrate. In such a manner, an electronic device having the element-formed region sealed in a glass panel was prepared and subjected to the after-mentioned evaluation of properties.

### EXAMPLE 3

First and second pastes for a sealing material were prepared in the same manner as in Example 1 except that tin-phosphate glass frit having a composition comprising, by mass ratio, 63.3% of SnO, 2.3% of SnO₂, 31.2% of P₂O₅ 3.0% of ZnO and 0.2% of SiO₂ was used. The thermal expansion coefficient of a mixture of the tin-phosphate glass frit with the zirconium phosphate powder is 45×10⁻⁷/°C.

Then, on the outer peripheral region of the same second glass substrate as in Example 1, the first paste for a sealing material was applied by a screen printing method. The first coating layer was subjected to leveling treatment for 1 minute (standard time) and dried at 150°C for 5 minutes. Then, in the same manner as in Example 1, the second paste for a sealing material was applied and dried and then fired at 430°C for 10 minutes to form a sealing material layer. The thickness (after dried) of the first coating layer was 17 µm, and the total thickness (after dried) after application of the second paste for a sealing material was 35 µm. The thickness of a sealing material layer formed by firing the laminate film of such coating layers is 31 µm.

The second glass substrate having the sealing material layer and a first glass substrate comprising alkali-free glass (thermal expansion coefficient: 38×10⁻⁷/°C) having an element-formed region (a region on which an OEL element was formed) were laminated. Then, the sealing material layer was irradiated with a laser light (semiconductor laser) having a wavelength of 940 nm at an output of 25 W at a scanning rate of 10 mm/s through the second glass substrate to melt and quench to solidify at least the layer of the second glass material for sealing thereby to bond the first glass substrate and the second glass substrate. In such a manner, an electronic device having the element-formed region sealed in a glass panel was prepared and subjected to the after-mentioned evaluation of properties.

### EXAMPLE 4

Bismuth glass frit (softening point: 420°C) having a composition comprising, by mass ratio, 82.0% of Bi₂O₃, 6.5% of B₂O₃, 11.0% of ZnO and 0.5% of Al₂O₃ and having an average particle size of 2 µm, a cordierite powder having an average particle size of 1 µm as a low-expansion filler, and a laser absorbent having the same composition and average particle size as in Example 1, were prepared. Further, 3 mass% of ethyl cellulose as a binder component was dissolved in 97 mass% of a mixed solvent comprising terpineol (48.5%) and butyl carbitol acetate (51.5%) to prepare a vehicle.

92 Mass% of the bismuth glass frit and 8 mass% of the cordierite powder were mixed. The thermal expansion coefficient of the mixture is 82×10⁻⁷/°C. 84 Mass% of the mixture (first glass material for sealing) of the glass frit with the low-expansion filler was mixed with 16 mass% of the vehicle to prepare a first paste for a sealing material. Then, 100 parts by mass of the mixture of the glass frit with the low-expansion filler was mixed with 3 parts by mass (2.9 mass% to the glass material for sealing) of the laser absorbent, and 84 mass% of this mixture (second glass material for sealing) was mixed with 16 mass% of the vehicle to prepare a second paste for a sealing material.

Then, on the outer peripheral region of a second glass substrate (dimensions: 100x100x0.55 mmt) comprising soda lime glass (thermal expansion coefficient: 87x 10⁻⁷/°C), the first paste for a sealing material containing no laser absorbent was applied by a screen printing method. The resulting first coating layer was subjected to leveling treatment for one minute and then dried at 130°C for 5 minutes. On the first coating layer after dried, the second paste for a sealing material containing a laser absorbent was applied by a screen printing method. The resulting second coating layer was dried at 130°C for 5 minutes. The thickness (after dried) of the first coating layer was 13 µm, and the total thickness (after dried) after application of the second paste for a sealing material was 26 µm. The laminate film of such coating layers was fired at 460°C for 10 minutes to form a sealing material layer having a thickness of 22 µm.

The second glass substrate having the sealing material layer and a first glass substrate comprising soda lime glass (thermal expansion coefficient: 87×10⁻⁷/°C) having an element-formed region (a region on which an OEL element was formed) were laminated. Then, the sealing material layer was irradiated with a laser light (semiconductor laser) having a wavelength of 940 nm at an output of 35 W at a scanning rate of 2 mm/s through the second glass substrate to melt and quench to solidify at least the layer of the second glass material for sealing thereby to bond the first glass substrate and the second glass substrate. In such a manner, an electronic device having the element-formed region sealed in a glass panel was prepared and subjected to the after-mentioned evaluation of properties.

### EXAMPLE 5

First and second pastes for a sealing material were prepared in the same manner as in Example 4 except that 100 parts by mass of the mixture of the glass frit with the low-expansion filler was mixed with 6 parts by mass (5.7 mass% in the materials) of the laser absorbent for the second glass material for sealing. On the outer peripheral region of the same second glass substrate as in Example 4, the first paste for a sealing material was applied by a screen printing method and subjected to leveling treatment for 5 minutes and then dried at 150°C for 5 minutes. Then, in the same manner as in Example 4, the second paste for a sealing material was applied and dried and then fired at 460°C for 10 minutes to form a sealing material layer. The thickness (after dried) of the first coating layer was 13 µm, and the total thickness (after dried) after application of the second paste for a sealing material was 27 µm. The thickness of a sealing material layer formed by firing the laminate film of the coating layers is 19 µm.

The second glass substrate having the sealing material layer and a first glass substrate having an element-formed region (a region on which an OEL element was formed) were laminated. Then, the sealing material layer was irradiated with a laser light (semiconductor laser) having a wavelength of 940 nm at an output of 55 W at a scanning rate of 5 mm/s through the second glass substrate to melt and quench to solidify at least the layer of the second glass material for sealing thereby to bond the first glass substrate and the second glass substrate. In such a manner, an electronic device having the element-formed region sealed in a glass panel was prepared and subjected to the after-mentioned evaluation of properties.

### EXAMPLE 6

First and second pastes for a sealing material were prepared in the same manner as in Example 4 except that a cordierite powder having an average particle size of 4 µm was used as a low-expansion filler and that 100 parts by mass of the mixture of the glass frit with the low-expansion filler was mixed with 6 parts by mass (5.7 mass% to the glass material for sealing) of the laser absorbent were mixed for the second glass material for sealing. In the same manner as in Example 4, such pastes for a sealing material were applied on the outer peripheral region of the second glass substrate in order and then fired at 460°C for 10 minutes to form a sealing material layer. The thickness (after dried) of the first coating layer was 13 µm, and the total thickness (after dried) after application of the second paste for a sealing material was 27 µm. The thickness of a sealing material layer formed by firing the laminate film of the coating layers was 19 µm.

The second glass substrate having the sealing material layer and a first glass substrate having an element-formed region (a region on which an OEL element was formed) were laminated. Then, the sealing material layer was irradiated with a laser light (semiconductor laser) having a wavelength of 940 nm at an output of 80 W at a scanning rate of 10 mm/s through the second glass substrate to melt and quench to solidify at least the layer of the second glass material for sealing thereby to bond the first glass substrate and the second glass substrate. In such a manner, an electronic device having the element-formed region sealed in a glass panel was prepared and subjected to the after-mentioned evaluation of properties.

### COMPARATIVE EXAMPLE 1

Only the first paste for a sealing material in Example 4 was applied on the outer peripheral region of a second glass substrate (soda lime glass) and fired at 460°C for 10 minutes to form a sealing material layer. The thickness of the coating layer after dried was 27 µm. The thickness of a sealing material layer formed by firing the coating layer is 21 µm. Then, a first glass substrate comprising soda lime glass (thermal expansion coefficient: 87×10⁻⁷/°C) and the second glass substrate were laminated, and the sealing material layer was irradiated with a laser light having a wavelength of 940 nm at an output of 55 W at a scanning rate of 5 mm/s through the second glass substrate to melt and quench to solidify the sealing material layer thereby to bond the first glass substrate and the second glass substrate. An electronic device prepared in such a manner was subjected to the after-mentioned evaluation of properties.

### COMPARATIVE EXAMPLE 2

A first glass substrate comprising soda lime glass (thermal expansion coefficient: 87×10⁻⁷/°C) and a second glass substrate were bonded in the same manner as in Comparative Example 1 except that the output of the laser light applied to the sealing material layer was changed to 100 W. An electronic device prepared in such a manner was subjected to the after-mentioned evaluation of properties.

### COMPARATIVE EXAMPLE 3

Only the second paste for a sealing material in Example 4 (100 parts by mass of the mixture of the glass frit with the low-expansion filler was mixed with 2 parts by mass of the laser absorbent) was applied on the outer peripheral region of a second glass substrate (soda lime glass) and fired at 460°C for 10 minutes to form a sealing material layer. The thickness of the coating layer after dried was 26 µm. The thickness of a sealing material layer formed by firing the coating layer was 19 µm. Then, a first glass substrate comprising soda lime glass (thermal expansion coefficient: 87×10⁻⁷/°C) and the second glass substrate were laminated, and the sealing material layer was irradiated with a laser light having a wavelength of 940 nm at an output of 55 W at a scanning rate of 10 mm/s through the second glass substrate to melt and quench to solidify the sealing material layer thereby to bond the first glass substrate and the second glass substrate. An electronic device prepared in such a manner was subjected to the after-mentioned evaluation of properties.

### COMPARATIVE EXAMPLE 4

The first glass substrate and the second glass substrate were bonded in the same manner as in Comparative Example 3 except that the output of the laser light applied to the sealing material layer was changed to 100 W. An electronic device prepared in such a manner was subjected to the after-mentioned evaluation of properties.

### COMPARATIVE EXAMPLE 5

First, the first paste for a sealing material in Example 4 was applied (coating thickness: 13 µm) on the outer peripheral region of a second glass substrate (soda lime glass) and then fired at 460°C for 10 minutes. Then, the second paste for a sealing material in Example 4 was applied (coating thickness: 26 µm) on the first fired layer, and then fired at 460°C for 10 minutes. The thickness of a sealing material layer formed by means of firing steps twice, is 20 µm. Then, a first glass substrate comprising soda lime glass (thermal expansion coefficient: 87×10⁻⁷/°C) and the second glass substrate were laminated, and the sealing material layer was irradiated with a laser light having a wavelength of 940 nm at an output of 120 W at a scanning rate of 10 mm/s through the second glass substrate to melt and quench to solidify the sealing material layer thereby to bond the first glass substrate and the second glass substrate. An electronic device prepared in such a manner was subjected to the after-mentioned evaluation of properties.

In the above-described procedure for production of the glass panels in Examples 1 to 6, the surface roughness of the first coating layer was measured and as a result, a surface roughness of at least 0.2 µm by Ra was confirmed in each Example as shown in Table 1. Whereas, in the procedure for production of the glass panel in Comparative Example 5, the surface roughness of the first fired layer was measured and as a result, the surface roughness Ra was 0.12 µm. Further, the distribution of the laser absorbent in the sealing material layer was confirmed by an X-ray microanalyzer (EPMA) and as a result, it was confirmed that the laser absorbent was distributed not only in the layer of the second glass material for sealing but also in the layer of the first glass material for sealing. A concentration gradient of the laser absorbent in the sealing material layer was confirmed in a region of about 60% (about 30% in both sides of the interface) of the total thickness as the laminate interface being the center. Whereas, in Comparative Example, the laser absorbent was distributed only in the second fired layer.

Then, with respect to the outer appearance of the glass panels in Examples 1 to 6 and Comparative Examples 1 to 5, the substrate fracture, frit bubbles, and the state of the joint part (bonded part) were measured and evaluated. The outer appearance was observed by an optical microscope and evaluated. Further, the airtightness of each glass panel was measured. The airtightness was evaluated by employing helium leak test. The evaluation results are shown in Tables 1 and 2. Conditions for production of the glass panels are also shown in Tables 1 and 2.

**TABLE 1**

| | | | Ex. 1 | Ex.2 | Ex.3 | Ex.4 | Ex. 5 | Ex.6 |
|---|---|---|---|---|---|---|---|---|
| Sealing material paste (blend ratio/mass%) | Glass frit | | Tin-phosphate glass (53%) | | | Bismuth glass (92%) | | |
| | Low-expansion filler | Material | Zirconium phosphate (47%) | | | Cordierite (8%) | | |
| | | Average particle size | 3 | 7 | 3 | 1 | 1 | 4 |
| | Laser absorbent | First material | - | - | - | - | - | - |
| | | Second material | (4 parts) | (2 parts) | (4 parts) | (3 parts) | (6 parts) | (6 parts) |
| Coating layer | First coating thickness (µm) | | 17 | 34 | 17 | 13 | 13 | 13 |
| | Surface roughness of first coating layer Ra(µm) | | 0.46 | 0.42 | 0.55 | 0.25 | 0.31 | 0.29 |
| | Total coating thickness | | 35 | 70 | 35 | 26 | 27 | 27 |
| Sealing material layer | Thickness (µm) | | 31 | 63 | 31 | 22 | 19 | 19 |
| Glass substrate | | | Alkali-free glass | | | Soda lime glass | | |
| Laser light | Output (W) | | 30 | 25 | 30 | 35 | 55 | 80 |
| | Scanning rate (mm/s) | | 10 | 10 | 10 | 2 | 5 | 10 |
| Evaluation results | Outer appearance | Substrate fracture | Nil | Nil | Nil | Nil | Nil | Nil |
| | | Frit bubbles | Nil | Nil | Nil | Nil | Nil | Nil |
| | | Separation | Nil | Nil | Nil | Nil | Nil | Nil |

**TABLE 2**

| | | | Comp. Ex. 1 | Comp. Ex. 2 | Comp. Ex. 3 | Comp. Ex. 4 | Comp. Ex. 5 |
|---|---|---|---|---|---|---|---|
| Sealing material paste (blend ratio/mass%) | Glass frit | | Bismuth glass (92%) | | | | |
| | Low-expansion filler | | Cordierite (8%) | | | | |
| | Laser absorbent | First material | - | - | [Not used] | [Not used] | - |
| | | Second material | [Not used] | [Not used] | 2 parts) | (2 parts) | (4 parts) |
| Coating layer | First coating thickness (µm) | | 27 | 27 | [Not used] | [Not used] | 13* |
| | Total coating thickness (µm) | | [Not used] | [Not used] | 26 | 26 | 26* |
| Sealing material layer | Thickness (µm) | | 21 | 21 | 19 | 19 | 20 |
| Glass substrate | | | Soda lime glass | | | | |
| Laser light | Output (W) | | 55 | 100 | 55 | 100 | 120 |
| | Scanning rate (mm/s) | | 5 | 5 | 10 | 10 | 10 |
| Evaluation results | Outer appearance | Substrate fracture | Nil | Nil | Nil | Observed | Nil |
| | | Frit bubbles | Nil | Nil | Nil | Observed | Observed |
| | | Separation | Not bonded | Not bonded | Not bonded | Separated after bonding | Separated after bonding |
| | Airtightness | | Nil | Nil | Nil | Nil | Nil |

| | | | | | | | |
|---|---|---|---|---|---|---|---|
| *The first paste was applied and fired, and the second paste was applied thereon and fired. | | | | | | | |

As evident from Table 1, each of the glass panels in Examples 1 to 6 is excellent in the outer appearance and the airtightness. Whereas, in each of the glass panels in Comparative Examples 1 to 3 wherein the sealing material layer had a single layer structure, the glass substrates could not be bonded. In Comparative Example 4 wherein the laser output was increased, although the sealing layer was bonded to the glass substrates, it was separated from the interface with the second glass substrate. Further, in the second glass substrate, cracks, fracture and the like were confirmed. In Comparative Example 5 wherein the sealing material layer was formed by means of the firing steps twice, cracks formed in the sealing layer, and separation occurred.

In the above Examples, a combination of tin-phosphate glass for the glass frit and alkali-free glass for the glass substrate, and a combination of bismuth glass for the glass frit and soda lime glass for the glass substrate were employed. However, it is possible to suppress cracks, fractures, separation and the like of the glass substrates and the layers of the glass material for sealing, with a combination of tin-phosphate glass with soda lime glass or a combination of bismuth glass with alkali-free glass.

### INDUSTRIAL APPLICABILITY

The present invention is applicable to production of a glass member provided with a sealing material layer, and an electronic device such as a flat panel display device such as an organic EL display, a plasma display panel or a liquid crystal display device, or a dye-sensitized solar cell.

The entire disclosure of Japanese Patent Application No. 2008-291967 filed on November 14, 2008 including specification, claims, drawings and summary is incorporated herein by reference in its entirety.

### REFERENCE SYMBOLS

1: First glass substrate, 1 a: element-formed region, 1b: first sealing region, 2: second glass substrate, 2a: second sealing region, 3: sealing material layer, 4: layer of first glass material for sealing, 5: layer of second glass material for sealing, 11: first coating layer, 12: second coating layer, 13: laminate film, 14: laser absorbent, 15: laser light, 16: sealing layer, 17: electronic device.

## Claims

1. A process for producing a glass member provided with a sealing material layer, which comprises a step of preparing a glass substrate having a sealing region; a step of applying a first paste for a sealing material which contains a first glass material for sealing containing no laser absorbent and a second paste for a sealing material which contains a second glass material for sealing containing a laser absorbent, in this order on the sealing region of the glass substrate; and a step of firing a laminate film of a coating layer of the first paste for a sealing material and a coating layer of the second paste for a sealing material, to form a sealing material layer having a laminated structure of a layer of the first glass material for sealing and a layer of the second glass material for sealing on the sealing region.

2. The process for producing a glass member provided with a sealing material layer according to Claim 1, wherein the laser absorbent comprises at least one metal selected from Fe, Cr, Mn, Co, Ni and Cu or a compound containing the metal, and the second glass material for sealing contains the laser absorbent in an amount of from 0.1 to 10 mass%.

3. The process for producing a glass member provided with a sealing material layer according to Claim 1 or 2, wherein each of the first and second glass materials for sealing contains, as the main component, sealing glass comprising tin-phosphate glass or bismuth glass.

4. The process for producing a glass member provided with a sealing material layer according to any one of Claims 1 to 3, wherein each of the first and second glass materials for sealing contains a low-expansion filler in an amount of from 3 to 50 mass%.

5. The process for producing a glass member provided with a sealing material layer according to any one of Claims 1 to 4, wherein the laser absorbent is diffused via the interface between the coating layer of the first paste for a sealing material and the coating layer of the second paste for a sealing material.

6. The process for producing a glass member provided with a sealing material layer according to Claim 5, wherein the second paste for a sealing material is applied on the coating layer of the first paste for a sealing material having its surface roughened.

7. The process for producing a glass member provided with a sealing material layer according to any one of Claims 1 to 6, wherein the glass substrate comprises soda lime glass or alkali-free glass.

8. A process for producing an electronic device, which comprises a step of preparing a first glass substrate having an element-formed region provided with an electronic element and a first sealing region provided on the outer peripheral side of the element-formed region; a step of preparing a second glass substrate having a second sealing region corresponding to the first sealing region of the first glass substrate; a step of applying a first paste for a sealing material which contains a first glass material for sealing containing no laser absorbent and a second paste for a sealing material which contains a second glass material for sealing containing a laser absorbent, in this order on the second sealing region of the second glass substrate; a step of firing a laminate film of a coating layer of the first paste for a sealing material and a coating layer of the second paste for a sealing material, to form a sealing material layer having a laminated structure of a layer of the first glass material for sealing and a layer of the second glass material for sealing, on the second sealing region; a step of laminating the first glass substrate and the second glass substrate via the sealing material layer while a space is formed on the element-formed region; and a step of irradiating the sealing material layer with a laser light from the side of the layer of the first glass material for sealing through the second glass substrate to melt at least the layer of the second glass material for sealing thereby to seal the space between the first glass substrate and the second glass substrate.

9. The process for producing an electronic device according to Claim 8, wherein the laser absorbent is diffused via the interface between the coating layer of the first paste for a sealing material and the coating layer of the second paste for a sealing material.

10. The process for producing an electronic device according to Claim 8 or 9, wherein the electronic element is an organic EL element or a solar cell element.
